# EUROPEAN PATENT SPECIFICATION

(11) **EP 3 316 668 B1**
(45) Date of publication and mention of the grant of the patent: **08.04.2020**
(21) Application number: 16196038.0
(22) Date of filing: 27.10.2016
(51) Int. Cl.: H05K 5/00, H01R 13/639, H01R 13/74

(54) **A HOUSING UNIT**
GEHÄUSEEINHEIT
UNITÉ DE LOGEMENT

(43) Date of publication of application: 02.05.2018
(73) Proprietor: Veoneer Sweden AB, 447 83 Vårgårda (SE)
(72) Inventor: Kuehne, Viktor, 13595 Berlin (DE); Brandenburg, Uwe, 88677 Markdorf (DE)
(74) Representative: Beattie, Alex Thomas Stewart

(56) References cited:
- DE-A1- 10 162 405
- US-A- 4 124 267
- US-A1- 2009 042 439
- US-B1- 6 657 869
- US-B1- 8 657 622

## Description

This invention relates to a housing unit, and in particular concerns a housing unit for electronic components within a vehicle.

Modern motor vehicles include several electronic components that need to be held within respective housings. Examples include the main processor or electronic control unit (ECU), and also sensors such as radar sensors.

US 6,657,869 discloses a housing, particularly for use for an airbag control device, which includes a metal body having top, bottom, rear and side walls. The body has an open front which engages with a plastic terminating element, which includes electrical connections. The terminating element engages with the body through detents which cooperate with connection apertures formed in the side walls of the body.

US2009/0042439 discloses a computer enclosure including a chassis and a connector. The chassis includes a bottom panel and a side panel perpendicular to the bottom panel. The side panel defines an opening. A positioning flange protrudes from the side panel parallel to the bottom panel. Two resilient hooks extend from the side panel at opposite sides of the opening. The connector is mounted in the opening. The connector includes a first face, a second face parallel to the first face and a top wall perpendicular to the first and second faces. Two ends of the first face are engaged with the corresponding resilient hooks. The second face abuts against the side panel. The positioning flange abuts against the top wall of the connector, thereby the connector is sandwiched between the positioning flange and the bottom panel.

US4124267 discloses a mounting clip which is adapted to mount an electrical connector or the like in a cutout in a mounting panel. The clips are mounted in place on the panel in pairs and securely engage end portions of a clip by a simple "snap" action without the need for tools or securing means such as screws or the like. The connector is readily disengaged from one of the clips by a simple clip-bending step effected by a tool such as a screwdriver, pen knife or the like, so as to free one connector end, whereafter the opposed connector end may be readily slid from engagement with the remaining clip without damaging the connector or the clips whereby they may be reused indefinitely.

It is an object of the present invention to provide an improved housing of this type.

Accordingly, one aspect of the present invention provides a housing suitable for containing one or more electronic components, the housing having a connection aperture formed in a wall thereof to allow connection of a cable to the wall, wherein the connection aperture is provided with a pair of tabs positioned on opposing sides thereof, the tabs being configured to hold firmly in place a connector which is inserted into the connection aperture, each tab being generally elongate and having a free end, each tab being cut out from the wall of the housing, and attached to the wall of the housing at an attachment region, each tab being deflected with respect to the wall and extending inwardly into the interior of the housing at an angle to the plane of the wall, so the free end of each tab lies within the housing, and wherein each tab has a first region, which is near or adjacent the wall, which extends at a first angle with respect to the plane of the wall, and a second region, which is further from the wall that the first region, which extends at a second angle with respect to the plane of the wall, the second angle being less than the first angle.

Conveniently, the connection aperture has an inward-facing lip on at least one side thereof, and a part of a connection element is received within a gap between the lip and a wall of the housing to retain the connection aperture in place.

Advantageously, the part of the connection aperture comprises an upstanding wall or skirt.

Preferably, the part of the connection aperture is clamped or received in an interference fit between the lip and a wall of the housing.

Conveniently, the first region extends at an angle of around 90° with respect to the plane of the wall, and the second region extends, at its free end, in a direction which has a component pointing towards the other of the tabs.

Advantageously, each tab has a shape which includes a pair of substantially parallel tongues extending away from the attachment region, there being a cut out region between the tongues.

Preferably, the housing defines a generally substantially enclosed interior, aside from the connection aperture.

Conveniently, the height of each tab is at least 80% of the height of the connection aperture, and is preferably at least 90% of the height of the connection aperture.

Another aspect of the present invention provides a housing according to any preceding claim in combination with a connector which is sized to fit into the connection aperture to provide an electrical connection between the interior of the housing and the exterior of the housing, wherein the connector has a leading end and a pair of rearwardly-facing shoulders formed behind the leading end, the connector being dimensioned so that, when the leading end of the connector is inserted into the connection aperture, the tabs are initially deflected outwardly from their resting positions by the leading end, but then return to their resting positions where the free end of the tabs lie against the respective rearwardly-facing shoulders of the connector.

Advantageously, the connector further comprises an outwardly-extending flange region, the flange region being spaced from the rearwardly-facing shoulders such that, when the connector is inserted into the connection aperture, when the free end of the tabs rest against the respective rearwardly-facing shoulders of the connector, a front surface of the flange portion lies against or adjacent an outer surface of the wall of the housing.

A further aspect of the present invention provides a method of forming a connection aperture in a wall of a housing, comprising the steps of: forming one or more cuts in a wall of the housing to form a pair of tabs, each tab being generally elongate and being attached to the housing at an attachment region, and having a free end; and deflecting each tab at or near the attachment region with respect to the wall so that each tab extends inwardly into the interior of the housing at an angle to the plane of the wall, so the free end of each tab lies within the housing, and wherein each tab has a first region, which is near or adjacent the attachment region, which extends at a first angle with respect to the plane of the wall, and a second region, which is further from the attachment region that the first region, which extends at a second angle with respect to the plane of the wall, the second angle being less than the first angle, wherein the tabs are configured to hold firmly in place a connector which is inserted into the connection aperture.

Preferably, the step of deflecting each tab includes the step of deflecting each tab so that the first region extends at an angle of around 90° with respect to the plane of the wall, and the second region extends at its free end, in a direction which has a component point pointing towards the other of the tabs.

Conveniently, the step of forming cuts in the wall of the housing to form a pair of tabs comprises forming cuts so that each tab has a shape which includes a pair of substantially parallel tongues extending away from the attachment region, there being a cut-out region between the tongues.

Advantageously, the connection aperture is formed in the wall of a housing which defines a generally substantially enclosed interior, aside from the connection aperture.

Preferably, the step of forming cuts in the wall of the housing to form a pair of tabs comprises forming cuts such that the height of each tab is at least 80% of the height of the connection aperture, and is preferably at least 90% of the height of connection aperture.

In order that the present invention may be more readily understood, embodiments thereof will now be described, with reference to the accompanying drawings, in which:
Figure 1 shows a step in production of a housing embodying the present invention;
Figure 2 shows a cut-away view of a part of a housing embodying the present invention;
Figure 3 shows a close-up view of one of the tabs of figure 2;
Figure 4 shows a connector suitable for connection with housing embodying the present invention;
Figure 5 shows a combination of a housing and a connector embodying the present invention;
Figure 6 shows a further view of the connector of figure 4, along with a PCB; and
Figures 7, 8 and 9 show a connection element not embodying the present invention.

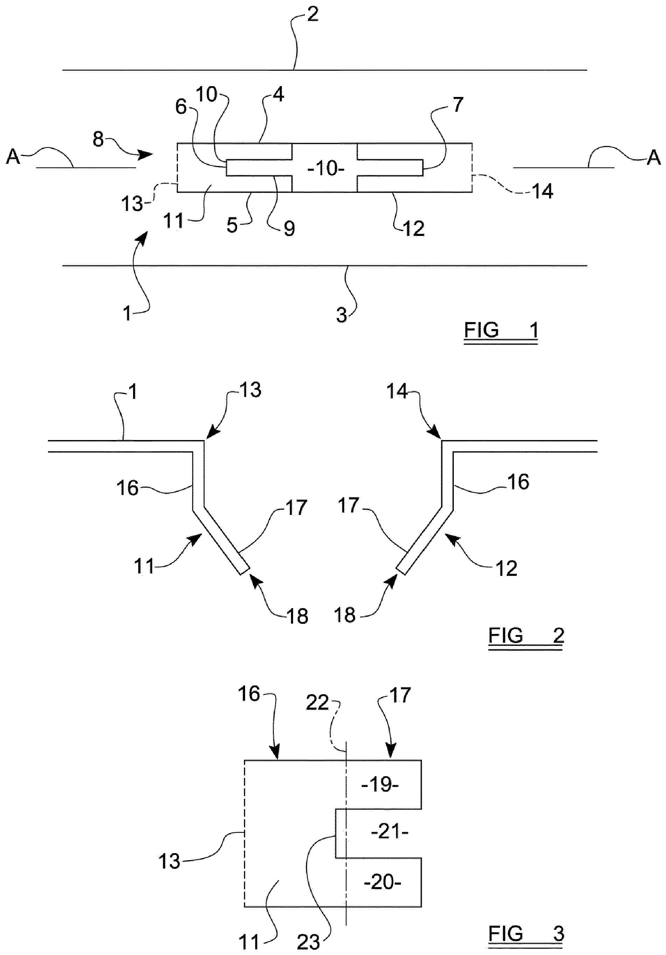

Embodiments of the invention involve a main body, which is formed from a robust material such as metal. The main body may, for example, be formed from steel, aluminium or another suitable material. Referring firstly to figure 1, a side wall 1 of a main body is shown, during production of a finished housing embodying the present inventories. The side wall 1 extends between a top wall 2 and bottom wall 3, as will be described in more detail below.

First and second cuts 4, 5 are formed through the thickness of the side wall 1. The first and second cuts 4, 5 are preferably straight and parallel with one another. The first and second cuts 4, 5 are also preferably of the same or substantially the same length, and are aligned with each other.

The length of each of the first and second cuts 4, 5 may be around 13-15mm, in one example, but the invention is not limited to this.

Two bridging cuts 6, 7 extend between the first and second cuts 4, 5. A first bridging cut 6, 7 is closer to a first end 8 of the first and second cuts 4, 5. The first bridging cut 6 extends generally directly between the first and second cuts 4, 5 but includes a generally rectangular tongue 9 which extends toward, but does not reach, the first end 8. The tongue 9 is defined by regions of the first bridging cut 6 that extend generally parallel to the first and second cuts 4, 5. The tongue 9 has a generally straight end portion 10, which is preferably substantially perpendicular to the first and second cuts 4, 5.

The second bridging cut 7 is closer to a second, opposite end of the first and second cuts 4, 5, and preferably generally takes the form of a mirror-image of the first bridging cut 6. The two bridging cuts 6, 7 are preferably symmetrically arranged with respect to a line that passes through the centres of the first and second cuts 4, 5, perpendicular thereto.

As can be seen in figure 1, there is a generally cross-shaped region 10 defined between the first and second cuts 4, 5 and the first and second bridging cuts 6, 7, that will become entirely detached from the side wall 1 and will be removed.

The cuts 4, 5, 6, 7 also create first and second tabs 11, 12. These tabs will, as is explained in more detail below, be bent inwardly with respect to the side wall 1 along hinge regions 13, 14, which are indicated by dotted lines in figure 1. The hinge regions 13, 14 generally extend between the ends of the first cuts 4, 5, substantially perpendicular thereto.

In the example shown, each tab 11, 12 substantially fully occupies the height of the connection aperture 15. In preferred embodiments each tab 11, 12 has a height which is at least 80% of the height of the connection aperture 15, and yet more preferably has a height which is at least 90% of the height of the connection aperture 15.

Figure 2 shows a schematic cutaway view of the side wall 1, taken through the line indicated by A-A in figure 1. In this view, the first and second tabs 11, 12 have been bent inwardly along the hinge regions 13, 14, and it will be appreciated that this forms a connection aperture 15 through the side wall 1. In the example shown the tabs 11, 12 are bent relatively sharply at the hinged regions 13, 14. However, the bends formed at the hinged regions 13, 14 may alternatively be more gradual, radiused bends.

Each tab has a first portion 16, which is adjacent to the appropriate hinged region 13, 14 and preferably extends in a direction which is perpendicular or substantially perpendicular to the plane of the side wall 1.

Each tab 11, 12 also has a second portion 17, furthest from the hinge regions 13, 14, which is angled inwardly with respect to the first region 16. In preferred embodiments, the second portion 17 of each tab 11, 12 is set an angle of approximately 15° relatively to a plane which is perpendicular to the plane of the side wall 1. To put it another way, the second portion 17 of each tab 11 is preferably set at an angle of 75° to the plane of the side wall 1.

In preferred embodiments, the first and second portions 16, 17 of each tab 11, 12 each occupy around half of the length of the tab 11, 12. In other embodiments one of the first and second portions 16, 17 may be longer than the other, although it is preferred that neither of the first and second portions 16, 17 is less than around a third of the length of the tab 11, 12.

Each of the second portions 17 terminates in a respective free end 18.

Figure 3 shows a schematic view of the first tab 11, bent inwardly around the hinge region 13. As can be understood from figure 1, the first tab 11 has a generally forked shape, having first and second protruding tongues, 19, 20, which are preferably generally rectangular in shape. A cut-out section 21, which is also generally rectangular in shape, exists between the tongues 19, 20. Overall the first tab 11 is generally "C"-shaped.

As can be understood from figure 2, a bend 22 is formed in the first tab 11 between the first portion 16 and second portion 17 thereof. Preferably, the bend 22 is formed at a distance from the hinge 13 such that the bend is formed only in the first and second tongues 19, 20. In other words, the bend 22 is formed further from the hinge region 13 than the inner end 23 of the cut-out section 21.

This need not be the case, however, and in other embodiments the bend 22 could be formed closer to the hinge region 13 than the inner end 23 of the cut out section 21.

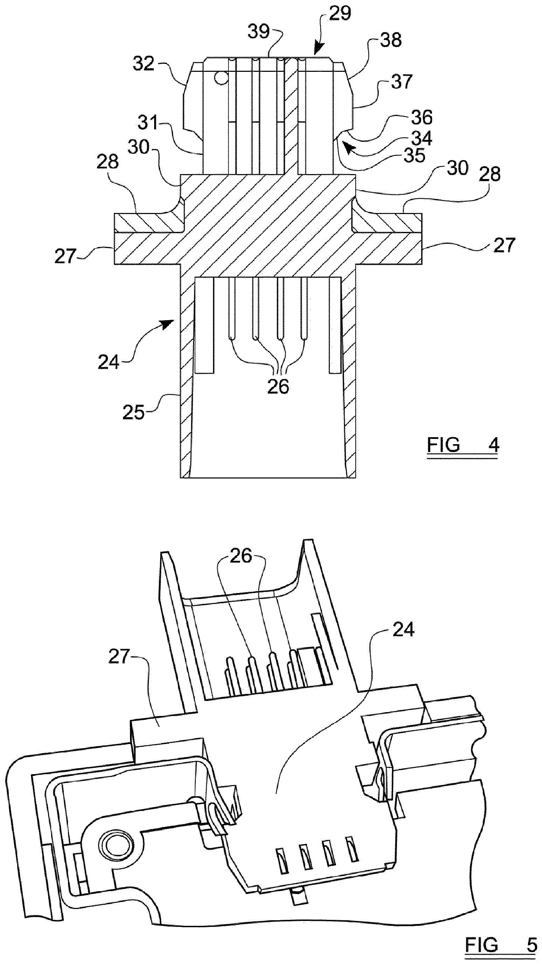

Figure 4 shows a connector 24 which is adapted to be connected to the connection aperture 15 formed as described above. The connector 24 comprises a generally elongate main body 25, having electrically conducting connectors 26 running therethrough. The connector 24 has a generally transverse flange portion 27 part-way along its length, which protrudes from both sides of the main body 25. In operation, a front surface 28 the flange portion 27 will abut against the outer surface of the side wall 1 of the main body.

The connector 24 includes an engagement portion 29, which protrudes forwardly from the flange portion 27 and which, in use, is intended to lie within the main body, i.e. on the interior side of side wall 1.

An initial portion 30 of the engagement portion 29 includes generally straight, parallel outer side walls, which are generally parallel with a longitudinal axis of the connector 24. A second portion 31, further from the flange portion 27 than the initial portion 30, is narrower than the first portion 30.

The connection portion 29 terminates in a third, widened portion 32. Between the second portion 31 and the third, widened portion 32, a pair of rearward-facing shoulders 34 are formed, one on each side of the connector 24. In the example shown in figure 4, an inner portion 35 of the shoulder is set at a relatively steep angle (in the example shown, around 45°) to the longitudinal axis of the connector 24. An outer portion 36 of the shoulder 34 is set to be perpendicular or almost perpendicular to the longitudinal axis of the connector. In preferred embodiments, the angle of the outer portion 36 of the shoulder 34 generally matches the angle at which the second portion 17 of each tab 11, 12 is set to the side wall 1. Therefore, in this example, the outer section 36 of the shoulder 34 is set at around 75° to the longitudinal axis of the connector 24.

Forwardly of the shoulder, the third, widened portion 32 has side walls 37 which are generally straight and parallel with the longitudinal axis of the connector 24, although at its forward-most portion the side wall 37 terminates in an inwardly-tapered portion 38. The engagement portion 29 terminates in a generally flat end wall 39, which is perpendicular or substantially perpendicular to the longitudinal axis to the connector 24.

Engagement of the connector 24 with the side wall 1 will now be described.

The widths of the third, widened portion 32, and of the first portion 30, of the engagement portion 29 are approximately the same as, or slightly less than, the width of the connection aperture 15.

As the forward-most part of the engagement portion 29 is inserted into the connection aperture 15, the third, widened portion 32 passes through the connection aperture 15, and contact the inwardly-deflected second portions 17 of the tabs 11, 12. The tabs 11, 12 are deflected outwardly as the connection portion 29 is introduced, and this is assisted by the tapered portions 38 formed near the end of the connection portion 29.

Once the third, widened portion 32 of the connection portion 29 has been pushed all the way past the free ends 18 of the tabs 11, 12, the tabs 11, 12 spring back inwardly, so the free ends 18 thereof rest on the rearward-facing shoulders 34 formed between the second and third portions 31, 32 of the connection portion 29. At this point, the front surface 28 of the flange portion 27 is abutted against the outer surface of the side wall 1. It will therefore be understood that the distance from the front surface 28 of the flange portion 27 to the rearward-facing shoulders 34 is approximately the same as, or slightly greater than, the distance from the outer surface of the side wall 1 and the free end 18 of each tab 11, 12.

It will be understood that, once the connector 24 has been inserted in this way, it will not be possible to remove the connector 24 from the side wall 1 by simply pulling it directly away from the side wall 1, as the tabs 11, 12 will abut against the rearwardly-facing shoulders 34 of the connection portion 29, thereby resisting this movement.

This arrangement is shown in figure 5. As can be seen in this figure, the side walls of the first portion 30 of the connection portion 29 lie against the inner surfaces of the first portion 16 of each tab 11, 12, thereby providing robust resistance to any lateral movement of the connector 24 with respect to the side wall 1. Although not visible in this figure, the height of the first portion 30 of the connector 24 also matches closely the height of the connection aperture 15, and so motion of the connector 24 with respect to the side wall 1 in a direction generally parallel with the side wall 1 but perpendicular to the width of the connection aperture 15 will also be strongly resisted.

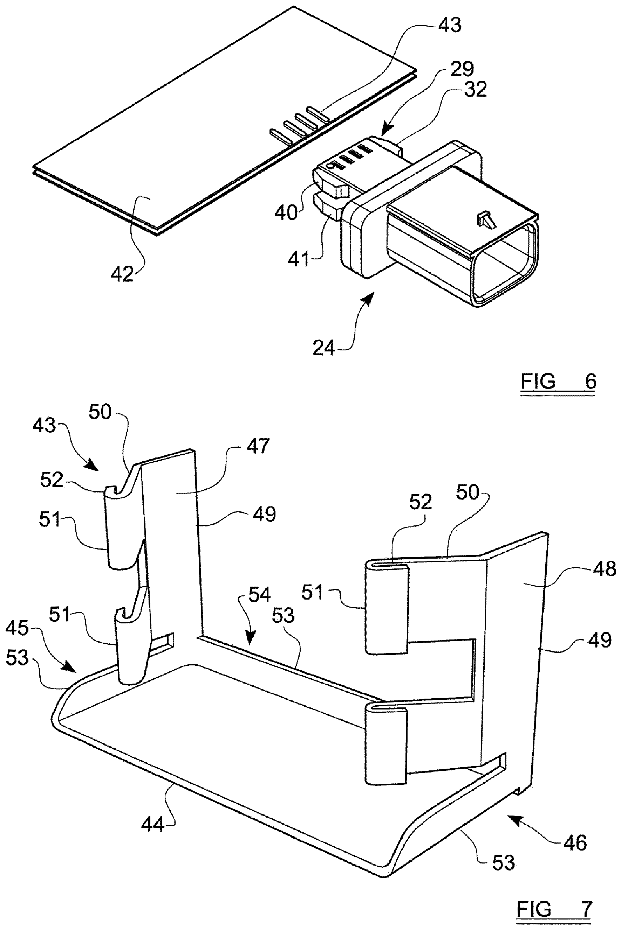

With reference to figure 6, a perspective view of the connector 24 is shown. As can be seen in this figure, in preferred embodiments the third, widened portion 32 of the connector portion 29 has spaced apart first and second layers 33, 34, each of which has the external shape shown in figure 4, having first, second and third portions 30, 31, 32. Preferably, a space is defined between the first and second layers 33, 34.

As the skilled reader will appreciate, with this design one of each of tongues 19, 20 of each of the tabs 11, 12 may rest against the rearwardly-facing shoulder 34 of the respective first and second layers 40, 41.

Also visible in figure 6 is a PCB 42, which will be housed within the main body. The PCB 42 is (in this example) generally rectangular in shape, and has a series of sliding connectors 43 formed on one side thereof. The first and second layers 40, 41 are spaced apart by a suitable distance so that the PCB 42 can fit between the layers. Preferably, the PCB 42 fits snugly between the layers 40, 41 so that, where it is held by the layers 40, 41, it cannot substantially move or vibrate in a direction perpendicular to the plane of the PCB 42. The layers 40, 41 may have features which cooperate with the sliding connectors 43 of the PCB 42, to help hold the PCB 42 in place with respect to the connector 24.

In use, the connector 24 will provide a power and/or data connection between the PCB 42 and the exterior of the main body. The electrically conducting connectors 26 which run through the connector 24 contact electrical connectors on the PCB 42 for this purpose. The electrical connectors on the PCB 42 are preferably formed as part of the sliding connectors 43.

In embodiments of the invention, the PCB 42 is firmly mounted within the main body such that, when the connector 24 is connected to the main body in the manner described above, the connector 24 cooperates and connects with the PCB 42. This allows for a simple and robust connection (without any intermediate connectors between the connector 24 and the PCB 42 being needed), and also allows an efficient use of space within the main body.

The separated first and second levels 40, 41 of the connector 24, along with the forked shape of the tabs 11, 12, allow this connection between the connector 24 and the PCB 42, as the edge of the PCB 42 can fit between the layers 40, 41 and between the tongues 19, 20 of the forked shape of each tab 11, 12.

In other embodiments, however, the tabs may have a shape which is rectangular or substantially rectangular, without the forked design shown in figures 3 and 5. In these embodiments, the connection portion of the connector may not involve the design shown in figure 6, involving first and second separated layers 40, 41.

In practice, the side wall 1 may form part of a housing, which defines a generally enclosed space in which one or more electronic components may be provided. The housing may, in some embodiments, comprise a metal component which provides a substantially enclosed space aside from one open surface, for instance providing top, bottom, side and rear walls, but no front wall. A plastic retaining wall may be attached to the open end of the housing, using any suitable means to provide an entirely or substantially enclosed space within the housing. A construction of this type may be suitable for a radar sensor, where the plastic side of the housing allows the radar signal to pass through.

In other embodiments the housing may be formed entirely from metal walls to form an entirely or substantially enclosed space. The skilled reader will understand that the housing may take any suitable form, and need not have any particular (such as oblong) shape.

A connection aperture 15 is formed in one of the metal walls of the housing, as described above. While the formation of the connection aperture 15 above is particularly described in relation to a side wall, this is not necessarily the case and the connection aperture may be formed in any appropriate surface of the housing. In some examples the wall of the housing in which the connection aperture 15 is formed is entirely or partially curved, and references to the plane of the wall in which the connection aperture is formed should be interpreted as references to the plane of the wall at the point where the connection aperture is formed.

Once the connection aperture 15 has been formed, a connector 24 may then be inserted into the connection aperture 15 so that it is firmly held in place, as discussed above. The electronic components held within the housing may then communicate with the exterior of the housing through electrical connectors (such as the electrical connectors 27 shown in figures 4 and 5).

It will be understood that the formation of a connection aperture of this type provides several advantages. Firstly, the formation of the tabs 11, 12, using punched-out sections of the metal wall of the housing is a cheap, simple and robust method of forming connection means on the housing that will cooperate with a connector to hold the connector in place.

The connection itself is also effective. Once inserted in place as shown in figure 5, the connector 24 may not move laterally with respect to the side wall 1, either in the left-right or up-down direction, as surfaces of the connector 24 are abutted against inward-facing surfaces of the connection aperture 15. Moreover, the connector 24 may not be removed directly outwardly from the housing, because the free ends 18 of the tabs 11, 12 are abutted firmly against the inward-facing shoulders 34 of the connection member 29.

Figure 7, 8 and 9 show as alternative connection element 43, not part of the present invention.

With reference to figure 7, the connection element 43 comprises a baseplate 44 which is, in the example shown, generally planar and rectangular. At first and second opposing ends 45, 46 of the baseplate 44, side portions 47, 48 are bent upwardly so they are substantially perpendicular with respect to the plane of the baseplate 44. The side portions 47, 48 are shaped and configured in the same way as, or a similar way to, the tabs 11, 12 of the sidewall 1, as described above. Each side portion 47, 48 therefore has a first generally flat portion 49 which is arranged to be perpendicular or substantially perpendicular to the plane of the baseplate 44. Each side portion 47, 48 further has a second portion 50, which is deflected inwardly, away from the plane of the first portion 49, towards the other of the side portions 47, 48.

Each of the first, generally flat portions 49 has an edge, furthest from the respective second portion 50, which is preferably aligned or substantially aligned with a front edge 59 of the baseplate 44, which extends between the first and second opposing ends 45, 46 thereof.

Each second portion 50 is also shaped to be in a "forked" configuration as is the case for the tabs 11, 12 described above.

In contrast to the tabs 11, 12 described above, the distal end 51 of each of the forked portions is turned back on itself, by being bent outwardly (i.e. away from the other one of the side portions 47, 48). In the example shown, each of the forked portions is curved through 180°, and terminates in a short end portion 52 which lies parallel or substantially parallel with the main part of the forked portion.

Finally, short, upstanding skirts 53 are provided at the first and second ends 45, 46 of the base plate 44, and also on the front edge 59 thereof.

In preferred embodiments the connection element 43 is formed from a single sheet of a robust material such as steel. The sheet is initially planar and is cut, stamped or otherwise formed into the correct shape, and then bent into the configuration shown in figure 7. In particular, pieces of the sheet to the sides of the baseplate 44 are bent to form the first and second tabs 47, 48, and also to form the skirts 53 that are formed at the first and second ends, 45, 46 and front edge 59 of the baseplate 44.

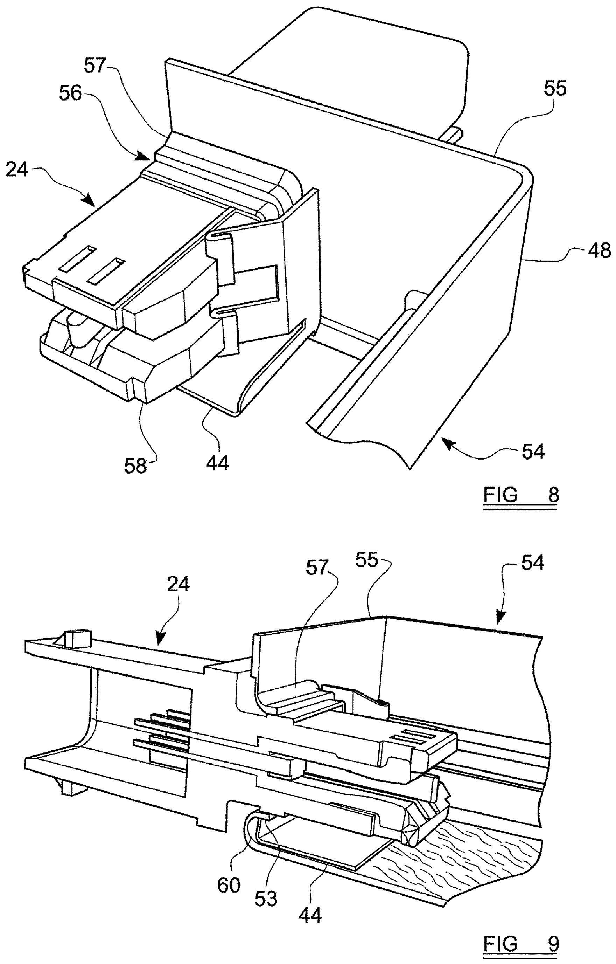

Figures 8 and 9 show views of the connection element 43 in use with a housing 54, which has a wall 55 with a connection aperture 56 formed therethrough. An inward-facing lip 57 is, in this embodiment, formed all of the way around the aperture 56. The connection element 43 is placed around the aperture 56 so that the baseplate 44 thereof lies on a bottom surface 58 of the housing, and the tabs 47, 48 are positioned on either side of the aperture 56.

As can be seen in figure 9, along the lower side of the connection aperture 56 the inward-facing lip 57 curves inwardly so that, at its free end, it lies parallel or substantially parallel with the bottom surface 58 of the housing. The free end of the inward-facing lip 57 preferably comprises a short, generally straight holding section 60.

As discussed above, the connection element 43 has a short, upstanding skirt 53 are provided on its front edge 59. In preferred embodiments, the height of the skirt 53 at the front edge 59 of the connection element 43 is substantially the same as, or slightly greater than, the distance between the bottom surface 58 of the housing and the free end of the inward-facing lip 57.

As can be seen in figure 9, during assembly the skirt 53 at the front edge 59 of the connection element 43 is positioned between the bottom surface 58 of the housing and the free end of the inward-facing lip 57, so that it is clamped or otherwise held firmly between the bottom surface 58 of the housing and the free end of the inward-facing lip 57.

In preferred arrangements, this will hold the connection element 43 in place with respect to the housing, the skirt 53 will be held in place sufficiently firmly to resist movement of the connection element 43 in a direction parallel with the bottom surface 58 of the housing when a connector is inserted into the connection aperture 56. Rotational motion of the connection element 43 about its front edge 59 will also be strongly resisted as a result of the baseplate 44 of the connection element 43 lying against the bottom surface 58 of the housing.

In the above example the skirt is clamped between the lip and the bottom wall of the housing. In other examples, however, the skirt may be clamped between a suitable lip and another wall of the housing, for instance a side wall or top wall. Indeed, the connection element may have two or more skirts which are clamped against respective different walls of the housing by suitable lips surrounding the connection aperture.

Alternatively, or in addition, the connection element may be rigidly connected to the interior of the main body, for instance by welding. In particular, the baseplate 44 may be connected to the bottom surface 58 of the main body 54.

As the connector 24 is pushed through the aperture 56, the tabs 47, 48 interact with the connector 24 in the same manner as the tabs 11, 12 described above in relation to the first embodiment.

The fact that the distal ends of the forked portions are turned back on themselves leads to increased robustness of the tabs 47, 48. The feature of the distal ends of the forked portions being tuned back on themselves in this manner may equally be applied to any of the other embodiments described in this application.

The connection element 43 may be useful in situations where it is desired for the tabs to be formed of a material that is more flexible than the material that forms the main body. The main body may need to be very strong and robust, and to be able to withstand heavy wear and sharp impacts. The material from which the walls of the main unit are formed may therefore necessarily be very strong and rigid. In this case, having tabs which are stamped out of the material of the wall itself may be inappropriate, because these tabs will not be sufficiently flexible.

For instance, it may be desirable for the main unit to be formed from steel (or another suitable material) having a high ductility, to allow the main unit to be formed using a deep-drawing or similar process. However, steel of this kind may not be ideal for forming the tabs, and it may be preferable to form the tabs from spring steel, or another material having a high yield strength. Therefore, the provision of a separate connection element allows these parts of the housing to be formed from different materials which are each well-suited to their respective purposes.

The presence of the baseplate 44 in the connection element 43 allows the connection element 43 to be firmly and reliably connected to the interior of the main body.

In addition, the edge of each first, generally flat portions 49 of each side portion 47, 48 may, when the connection element 43 is installed, be against or close to the interior of the wall 55 of the main body, to the side of the connection aperture 56. The side portions 47, 48 will therefore be strongly braced to resist withdrawal of the connector 24 from the connection aperture 56.

Although the example described above includes a single connection element 43 that has both side portions 47, 48 attached thereto, in other examples two separate connection elements could be provided, with each connection element being separately attached to the interior of the main body, and having one side portion attached thereto. However, having only a single connection portion is preferred, as this is expected to be more robust and allow for a more simple overall construction.

## Claims

1. A housing suitable for containing one or more electronic components, the housing having a connection aperture (15) formed in a wall (1) thereof to allow connection of a cable to the wall (1), wherein the connection aperture (15) is provided with a pair of tabs (11, 12) positioned on opposing sides thereof, the tabs (11, 12) being configured to hold firmly in place a connector (24) which is inserted into the connection aperture (15), each tab (11, 12) being generally elongate and having a free end (18), **characterised in that** each tab (11, 12) is cut out from the wall (1) of the housing, and attached to the wall (1) of the housing at an attachment region (13, 14), each tab (11, 12) being deflected with respect to the wall (1) and extending inwardly into the interior of the housing at an angle to the plane of the wall (1), so the free end (18) of each tab (11, 12) lies within the housing, and wherein each tab (11, 12) has a first region (16), which is near or adjacent the wall (1), which extends at a first angle with respect to the plane of the wall (1), and a second region (17), which is further from the wall (1) that the first region (16), which extends at a second angle with respect to the plane of the wall (1), the second angle being less than the first angle.

2. A housing according to claim 1, wherein the first region (16) extends at an angle of around 90° with respect to the plane of the wall (1), and the second region (17) extends, at its free end (18), in a direction which has a component pointing towards the other of the tabs (11, 12).

3. A housing according to claim 1 or 2, wherein each tab (11, 12) has a shape which includes a pair of substantially parallel tongues (19, 20) extending away from the attachment region (13, 14), there being a cut out region (21) between the tongues (19, 20).

4. A housing according to any preceding claim, wherein the housing defines a generally substantially enclosed interior, aside from the connection aperture (15).

5. A housing according to any preceding claim, wherein the height of each tab (11, 12) is at least 80% of the height of the connection aperture (15), and is preferably at least 90% of the height of the connection aperture (15).

6. A housing according to any preceding claim in combination with a connector (24) which is sized to fit into the connection aperture (15) to provide an electrical connection between the interior of the housing and the exterior of the housing, wherein the connector (24) has a leading end and a pair of rearwardly-facing shoulders (34) formed behind the leading end, the connector (24) being dimensioned so that, when the leading end of the connector (24) is inserted into the connection aperture (15), the tabs (11, 12) are initially deflected outwardly from their resting positions by the leading end, but then return to their resting positions where the free end (18) of the tabs (11, 12) lie against the respective rearwardly-facing shoulders (34) of the connector (24).

7. A housing and connector (24) according to claim 6, wherein the connector (24) further comprises an outwardly-extending flange region (27), the flange region (27) being spaced from the rearwardly-facing shoulders (34) such that, when the connector (24) is inserted into the connection aperture (15), when the free end (18) of the tabs (11, 12) rest against the respective rearwardly-facing shoulders (34) of the connector (24), a front surface (28) of the flange portion (27) lies against or adjacent an outer surface of the wall of the housing.

8. A method of forming a connection aperture (15) in a wall (1) of a housing, comprising the steps of:
forming one or more cuts (4, 5, 6, 7) in a wall (1) of the housing to form a pair of tabs (11, 12), each tab (11, 12) being generally elongate and being attached to the housing at an attachment region (13, 14), and having a free end (18); and
deflecting each tab (11, 12) at or near the attachment region with respect to the wall (1) so that each tab (11, 12) extends inwardly into the interior of the housing at an angle to the plane of the wall (1), so the free end of each tab (11, 12) lies within the housing, and wherein each tab (11, 12) has a first region (16), which is near or adjacent the attachment region (13, 14), which extends at a first angle with respect to the plane of the wall (1), and a second region (17), which is further from the attachment region (13, 14) that the first region (16), which extends at a second angle with respect to the plane of the wall (1), the second angle being less than the first angle,
wherein the tabs (11, 12) are configured to hold firmly in place a connector (24) which is inserted into the connection aperture (15).

9. A method according to claim 8, wherein the step of deflecting each tab (11, 12) includes the step of deflecting each tab (11, 12) so that the first region (16) extends at an angle of around 90° with respect to the plane of the wall (1), and the second region (17) extends at its free end (18), in a direction which has a component pointing towards the other of the tabs (11, 12).

10. A method according to claim 8 or 9, wherein the step of forming cuts (4, 5, 6, 7) in the wall (1) of the housing to form a pair of tabs (11, 12) comprises forming cuts (4, 5, 6, 7) so that each tab (11, 12) has a shape which includes a pair of substantially parallel tongues (19, 20) extending away from the attachment region (13, 14), there being a cut-out region (21) between the tongues (19, 20).

11. A method according to any one of claims 8 to 10, where the connection aperture (15) is formed in the wall (1) of a housing which defines a generally substantially enclosed interior, aside from the connection aperture (15).

12. A method according to any one of claims 8 to 11, wherein the step of forming cuts (4, 5, 6, 7) in the wall (1) of the housing to form a pair of tabs comprises forming cuts (4, 5, 6, 7) such that the height of each tab (11, 12) is at least 80% of the height of the connection aperture (15), and is preferably at least 90% of the height of connection aperture (15).

## Patentansprüche

1. Gehäuse, das zur Aufnahme von einer oder mehreren elektronischen Komponenten geeignet ist, wobei das Gehäuse eine Anschlussöffnung (15) hat, die in einer Wand (1) davon ausgebildet ist, um den Anschluss eines Kabels an der Wand (1) zu ermöglichen, wobei die Anschlussöffnung (15) ein Paar Laschen (11, 12) aufweist, die auf gegenüberliegenden Seiten davon positioniert sind, wobei die Laschen (11, 12) so konfiguriert sind, dass sie einen in die Anschlussöffnung (15) eingesteckten Stecker (24) fest an Ort und Stelle halten, wobei jede Lasche (11, 12) allgemein länglich ist und ein freies Ende (18) hat, **dadurch gekennzeichnet, dass** jede Lasche (11, 12) aus der Wand (1) des Gehäuses ausgeschnitten und an der Wand (1) des Gehäuses in einer Befestigungsregion (13, 14) befestigt ist, wobei jede Lasche (11, 12) mit Bezug auf die Wand (1) abgelenkt ist und sich nach innen in das Innere des Gehäuses in einem Winkel zur Ebene der Wand (1) erstreckt, so dass das freie Ende (18) jeder Lasche (11, 12) innerhalb des Gehäuses liegt, und wobei jede Lasche (11, 12) eine erste Region (16) in der Nähe oder neben der Wand (1) hat, die sich in einem ersten Winkel mit Bezug auf die Ebene der Wand (1) erstreckt, und eine zweite Region (17) weiter von der Wand (1) entfernt als die erste Region (16) hat, die sich in einem zweiten Winkel mit Bezug auf die Ebene der Wand (1) erstreckt, wobei der zweite Winkel kleiner als der erste Winkel ist

2. Gehäuse nach Anspruch 1, wobei sich die erste Region (16) in einem Winkel von etwa 90° mit Bezug auf die Ebene der Wand (1) erstreckt und die zweite Region (17) sich an ihrem freien Ende (18) in eine Richtung mit einer Komponente erstreckt, die in Richtung der anderen der Laschen (11, 12) zeigt.

3. Gehäuse nach Anspruch 1 oder 2, wobei jede Lasche (11, 12) eine Gestalt hat, die ein Paar im Wesentlichen parallele Zungen (19, 20) beinhaltet, die sich von der Befestigungsregion (13, 14) weg erstrecken, wobei zwischen den Zungen (19, 20) eine Ausschnittregion (21) vorhanden ist.

4. Gehäuse nach einem vorherigen Anspruch, wobei das Gehäuse ein allgemein im Wesentlichen geschlossenes Inneres definiert, abgesehen von der Anschlussöffnung (15).

5. Gehäuse nach einem vorherigen Anspruch, wobei die Höhe jeder Lasche (11, 12) wenigstens 80 % der Höhe der Anschlussöffnung (15) und vorzugsweise wenigstens 90 % der Höhe der Anschlussöffnung (15) beträgt.

6. Gehäuse nach einem vorherigen Anspruch in Kombination mit einem Stecker (24), der so bemessen ist, dass er in die Anschlussöffnung (15) passt, um einen elektrischen Anschluss zwischen dem Inneren des Gehäuses und dem Äußeren des Gehäuses zu bewirken, wobei der Stecker (24) ein vorderes Ende und ein Paar nach hinten gewandte Schultern (34) hat, die hinter dem vorderen Ende ausgebildet sind, wobei der Stecker (24) so dimensioniert ist, dass beim Einsetzen des vorderen Endes des Stecker (24) in die Anschlussöffnung (15) die Laschen (11, 12) zunächst durch das vordere Ende aus ihrer Ruheposition nach außen abgelenkt werden, dann aber in ihre Ruheposition zurückkehren, in der das freie Ende (18) der Laschen (11, 12) an den jeweiligen nach hinten gewandten Schultern (34) des Steckers (24) anliegt.

7. Gehäuse und Stecker (24) nach Anspruch 6, wobei der Stecker (24) ferner eine sich nach außen erstreckende Flanschregion (27) hat, wobei die Flanschregion (27) von den nach hinten gewandten Schultern (34) so beabstandet ist, dass, wenn der Stecker (24) in die Anschlussöffnung (15) eingesetzt wird, eine vordere Fläche (28) des Flanschabschnitts (27) an oder neben einer Außenfläche der Wand des Gehäuses anliegt, wenn das freie Ende (18) der Laschen (11, 12) an den jeweiligen nach hinten gewandten Schultern (34) des Steckers (24) ruht.

8. Verfahren zum Bilden einer Anschlussöffnung (15) in einer Wand (1) eines Gehäuses, das die folgenden Schritte beinhaltet:
Bilden von einem oder mehreren Einschnitten (4, 5, 6, 7) in einer Wand (1) des Gehäuses, um ein Paar Laschen (11, 12) zu bilden, wobei jede Lasche (11, 12) allgemein länglich ist und in einer Befestigungsregion (13, 14) an dem Gehäuse befestigt ist und ein freies Ende (18) hat; und
Ablenken jeder Lasche (11, 12) in oder in der Nähe der Befestigungsregion mit Bezug auf die Wand (1), so dass sich jede Lasche (11, 12) nach innen in das Innere des Gehäuses in einem Winkel zur Ebene der Wand (1) erstreckt, so dass das freie Ende jeder Lasche (11, 12) innerhalb des Gehäuses liegt, und wobei jede Lasche (11, 12) eine erste Region (16) hat, die sich in der Nähe oder neben der Befestigungsregion (13, 14) befindet und die sich in einem ersten Winkel mit Bezug auf die Ebene der Wand (1) erstreckt, und eine zweite Region (17) hat, die weiter von der Befestigungsregion (13, 14) entfernt ist als die erste Region (16), die sich in einem zweiten Winkel mit Bezug auf die Ebene der Wand (1) erstreckt, wobei der zweite Winkel kleiner als der erste Winkel ist,
wobei die Laschen (11, 12) so konfiguriert sind, dass sie einen in die Anschlussöffnung (15) eingesteckten Stecker (24) fest an Ort und Stelle halten.

9. Verfahren nach Anspruch 8, wobei der Schritt des Ablenkens jeder Lasche (11, 12) den Schritt des Ablenkens jeder Lasche (11, 12) auf eine Weise beinhaltet, dass sich die erste Region (16) in einem Winkel von etwa 90° mit Bezug auf die Ebene der Wand (1) erstreckt und die zweite Region (17) sich an ihrem freien Ende (18) in eine Richtung mit einer Komponente erstreckt, die in Richtung auf die andere der Laschen (11, 12) zeigt.

10. Verfahren nach Anspruch 8 oder 9, wobei der Schritt des Bildens von Einschnitten (4, 5, 6, 7) in der Wand (1) des Gehäuses zur Bildung eines Paares von Laschen (11, 12) das Bilden von Einschnitten (4, 5, 6, 7) auf eine Weise beinhaltet, so dass jede Lasche (11, 12) eine Gestalt hat, die ein Paar im Wesentlichen parallele Zungen (19, 20) beinhaltet, die sich von der Befestigungsregion (13, 14) weg erstrecken, wobei zwischen den Zungen (19, 20) eine Ausschnittregion (21) vorhanden ist.

11. Verfahren nach einem der Ansprüche 8 bis 10, wobei die Anschlussöffnung (15) in der Wand (1) eines Gehäuses ausgebildet wird, das ein allgemein im Wesentlichen geschlossenes Inneres definiert, abgesehen von der Anschlussöffnung (15).

12. Verfahren nach einem der Ansprüche 8 bis 11, wobei der Schritt des Bildens von Einschnitten (4, 5, 6, 7) in der Wand (1) des Gehäuses zur Bildung eines Paares von Laschen das Bilden von Einschnitten (4, 5, 6, 7) auf eine Weise beinhaltet, dass die Höhe jeder Lasche (11, 12) wenigstens 80 % der Höhe der Anschlussöffnung (15) und vorzugsweise wenigstens 90 % der Höhe der Anschlussöffnung (15) beträgt.

## Revendications

1. Un logement apte à contenir un ou plusieurs composants électroniques, le logement présentant une ouverture de connexion (15) formée dans une paroi (1) de celui-ci pour permettre la connexion d'un câble à la paroi (1), l'ouverture de connexion (15) étant dotée d'une paire de languettes (11, 12) positionnées sur des côtés opposés de celle-ci, les languettes (11, 12) étant configurées pour maintenir fermement en place un connecteur (24) inséré dans l'ouverture de connexion (15), chaque languette (11,12) étant généralement allongée et présentant une extrémité libre (18), **caractérisé en ce que** chaque languette (11,12) est découpée dans la paroi (1) du logement, et attachée à la paroi (1) du logement au niveau d'une zone d'attache (13, 14), chaque languette (11, 12) étant déviée par rapport à la paroi (1) et s'étendant vers l'intérieur dans l'intérieur du logement selon un angle par rapport au plan de la paroi (1), de manière à ce que l'extrémité libre (18) de chaque languette (11, 12) se trouve à l'intérieur du logement, et dans lequel chaque languette (11, 12) présente une première zone (16), qui est proche de ou adjacente à la paroi (1), qui s'étend selon un premier angle par rapport au plan de la paroi (1), et une deuxième zone (17), qui est plus éloignée de la paroi (1) que la première zone (16), qui s'étend selon un deuxième angle par rapport au plan de la paroi (1), le deuxième angle étant inférieur au premier angle.

2. Un logement selon la revendication 1, dans lequel la première zone (16) s'étend selon un angle d'environ 90° par rapport au plan de la paroi (1), et la deuxième zone (17) s'étend, au niveau de son extrémité libre (18), dans une direction qui a un composant pointant vers l'autre des languettes (11,12).

3. Un logement selon la revendication 1 ou 2, dans lequel chaque languette (11, 12) a une forme qui comprend une paire de pattes sensiblement parallèles (19, 20) s'étendant à partir de la zone d'attache (13, 14), une zone découpée (21) se trouvant entre les pattes (19, 20).

4. Un logement selon n'importe quelle revendication précédente, dans lequel le logement définit un intérieur généralement sensiblement fermé, à part l'ouverture de connexion (15).

5. Un logement selon n'importe quelle revendication précédente, dans lequel la hauteur de chaque languette (11, 12) est au moins 80% de la hauteur de l'ouverture de connexion (15), et est de préférence au moins 90% de la hauteur de l'ouverture de connexion (15).

6. Un logement selon n'importe quelle revendication précédente en combinaison avec un connecteur (24) qui est dimensionné pour s'adapter dans l'ouverture de connexion (15) pour fournir une connexion électrique entre l'intérieur du logement et l'extérieur du logement, le connecteur (24) présentant une extrémité avant et une paire d'épaulements orientés vers l'arrière (34) formés derrière l'extrémité avant, le connecteur (24) étant dimensionné de manière à ce que, quand l'extrémité avant du connecteur (24) est insérée dans l'ouverture de connexion (15), les languettes (11, 12) sont d'abord déviées vers l'extérieur par rapport à leur position de repos par l'extrémité avant, mais ensuite retournent à leur position de repos dans laquelle l'extrémité libre (18) des languettes (11, 12) repose contre les épaulements orientés vers l'arrière respectifs (34) du connecteur (24).

7. Un logement et connecteur (24) selon la revendication 6, dans lequel le connecteur (24) comprend en sus une zone en bride s'étendant vers l'extérieur (27), la zone en bride (27) étant espacée des épaulements orientés vers l'arrière (34) de manière à ce que, quand le connecteur (24) est inséré dans l'ouverture de connexion (15), quand l'extrémité libre (18) des languettes (11, 12) repose contre les épaulements orientés vers l'arrière respectifs (34) du connecteur (24), une surface avant (28) de la partie en bride (27) repose contre ou au voisinage d'une surface extérieure de la paroi du logement.

8. Un procédé de formation d'une ouverture de connexion (15) dans une paroi (1) d'un logement, comprenant les étapes consistant à :
former une ou plusieurs coupures (4, 5, 6, 7) dans une paroi (1) du logement pour former une paire de languettes (11,12), chaque languette (11, 12) étant généralement allongée et étant attachée au logement au niveau d'une zone d'attache (13, 14), et présentant une extrémité libre (18) ; et
faire dévier chaque languette (11, 12) au niveau ou à proximité de la zone d'attache par rapport à la paroi (1) de manière à ce que chaque languette (11, 12) s'étende vers l'intérieur dans l'intérieur du logement selon un angle par rapport au plan de la paroi (1), afin que l'extrémité libre de chaque languette (11, 12) se trouve à l'intérieur du logement, et chaque languette (11, 12) présentant une première zone (16), qui est proche de ou adjacente à la zone d'attache (13,14), qui s'étend selon un premier angle par rapport au plan de la paroi (1), et une deuxième zone (17), qui est plus éloignée de la zone d'attache (13, 14) que la première zone (16), qui s'étend selon un deuxième angle par rapport au plan de la paroi (1), le deuxième angle étant inférieur au premier angle,
dans lequel les languettes (11,12) sont configurées pour maintenir fermement en place un connecteur (24) inséré dans l'ouverture de connexion (15).

9. Un procédé selon la revendication 8, dans lequel l'étape consistant à faire dévier chaque languette (11, 12) comprend l'étape consistant à faire dévier chaque languette (11, 12) de manière à ce que la première zone (16) s'étende selon un angle d'environ 90° par rapport au plan de la paroi (1), et la deuxième zone (17) s'étende au niveau de son extrémité libre (18), dans une direction qui a un composant pointant vers l'autre des languettes (11,12).

10. Un procédé selon la revendication 8 ou 9, dans lequel l'étape consistant à former des coupures (4, 5, 6, 7) dans la paroi (1) du logement pour former une paire de languettes (11, 12) comprend la formation de coupures (4, 5, 6, 7) telles que chaque languette (11, 12) ait une forme qui comprend une paire de pattes sensiblement parallèles (19, 20) s'étendant à partir de la zone d'attache (13, 14), une zone découpée (21) se trouvant entre les pattes (19, 20).

11. Un procédé selon une quelconque des revendications 8 à 10, dans lequel l'ouverture de connexion (15) est formée dans la paroi (1) d'un logement qui définit un intérieur généralement sensiblement fermé, à part l'ouverture de connexion (15).

12. Un procédé selon une quelconque des revendications 8 à 10, dans lequel l'étape consistant à former des coupures (4, 5, 6, 7) dans la paroi (1) du logement pour former une paire de languettes comprend la formation de coupures (4, 5, 6, 7) telles que la hauteur de chaque languette (11, 12) soit au moins 80% de la hauteur de l'ouverture de connexion (15), et soit de préférence au moins 90% de la hauteur de l'ouverture de connexion (15).
